# EUROPEAN PATENT APPLICATION

(11) **EP 2 284 903 A1**
(43) Date of publication of application: **16.02.2011**
(21) Application number: 10171105.9
(22) Date of filing: 28.07.2010
(51) Int. Cl.: H01L 31/0224, H01L 31/18

(54) **Photovoltaic cell substrate and method of manufacturing the same**

(30) Priority: 29.07.2009 KR 20090069378
(71) Applicant: Samsung Corning Precision Materials Co., Ltd., Gumi-si Gyeongsangbuk-do 730-360 (KR)
(72) Inventor: Yoo, Young Zo, 336-841, ChungCheongNam-Do (KR); Choi, Jae Young, 336-841, ChungCheongNam-Do (KR); Kim, Hyun Suk, 336-841, ChungCheongNam-Do (KR)
(74) Representative: Gulde Hengelhaupt Ziebig & Schneider

(57) **Abstract**

A photovoltaic cell substrate and a method of manufacturing the same. The photovoltaic cell substrate includes a transparent substrate and a transparent conductive film. The transparent conductive film includes zinc oxide (ZnO) which is doped with a dopant and is formed over the transparent substrate. A surface charge activated layer is formed on a surface of the transparent conductive film by Rapid-Thermal-Annealing.

## Description

### CROSS REFERENCE TO RELATED APPLICATION

The present application claims priority from Korean Patent Application Number 10-2009-0069378 filed on July 29, 2009, the entire contents of which application are incorporated herein for all purposes by this reference.

### BACKGROUND OF THE INVENTION

### Field of the Invention

The present invention relates to a photovoltaic cell substrate, and more particularly, to a photovoltaic cell substrate and a method of manufacturing the same, in which a transparent conductive film exhibits optical and electrical properties required in a photovoltaic cell and has excellent moisture resistance.

### Description of Related Art

Recently, as a solution to the shortage of energy resources and environmental pollution, high-efficiency photovoltaic cells are being actively developed. Photovoltaic cells are applied in various fields, which include electrical and electronic appliances, the supply of electrical power to houses and buildings, and industrial power generation. The most basic photovoltaic cell has structure like p-n junction diode. Photovoltaic cells can be categorized according to the material used in the light absorbing layer thereof. Photovoltaic cells can be categorized into a silicon photovoltaic cell, which uses silicon as the light absorbing layer; a compound photovoltaic cell, which uses, for example, Copper Indium Selenide (CIS: CuInSe₂) or Cadmium Telluride (CdTe) as the light absorbing layer; a dye-sensitized photovoltaic cell, in which photosensitive dye, which excite electrons by absorbing visible light, are bonded to the surface of nano-particles of a porous layer; a stacked photovoltaic cell, in which, for example, a plurality of amorphous silicon layers are stacked on one another, etc. In addition, photovoltaic cells can be categorized into bulk photovoltaic cells (including single crystalline silicon photovoltaic cells and polycrystalline silicon photovoltaic cells) or thin film photovoltaic cells (including amorphous silicon photovoltaic cells and polycrystalline silicon photovoltaic cells).

At present, bulk photovoltaic cells which use polycrystalline silicon, occupy 90% or more of the market. However, the cost of using bulk photovoltaic cells for power generation is three to ten times as expensive as when using existing power generation techniques, such as thermal power generation, nuclear power generation, or hydraulic power generation. This is mainly attributable to the high cost of crystalline silicon and the high manufacturing cost of the crystalline silicon photovoltaic cell, which is complicated to manufacture. Therefore, in recent days, amorphous silicon (a-Si:H) and microcrystalline silicon (µc-Si:H) thin film photovoltaic cells are being actively studied and commercially distributed.

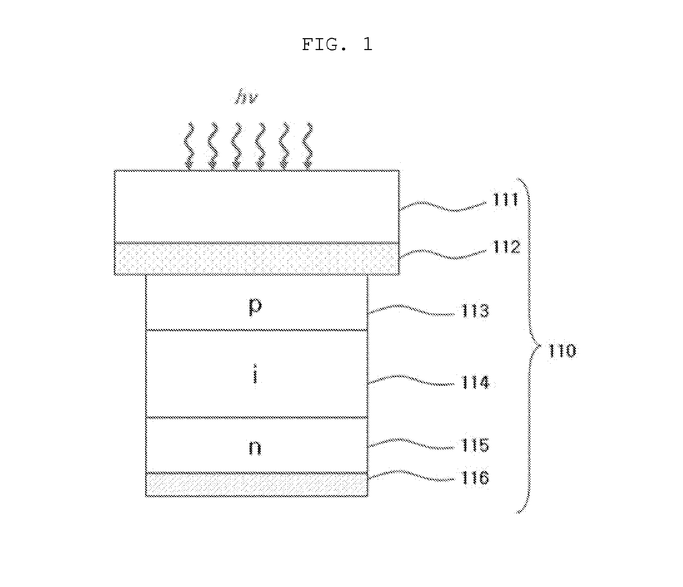

FIG. 1 is a cross-sectional view showing the structure of a photovoltaic cell 110 using amorphous silicon as a light-absorbing layer in the related art.

As shown in FIG. 1, the conventional amorphous silicon (e.g., a-Si:H) photovoltaic cell 110 includes a transparent substrate 111, a transparent conductive film 112, a p-type amorphous silicon (a-Si:H) layer 113, which is doped with a dopant, an i-type (intrinsic) amorphous silicon (a-Si:H) layer 114, which is not doped with a dopant, an n-type amorphous silicon (a-Si:H) layer 115, which is doped with a dopant, and a back reflector film 116. In the i-type amorphous silicon (a-Si:H) layer 114, depletion occurs under the influence of the p-type and n-type amorphous silicon (a-Si:H) layers 113 and 115, thereby generating an electric field. An electron-hole pair created in the i-type amorphous silicon (a-Si:H) layer 114 in response to incident light (hν) is drifted by the internal electric field and is then collected by the p-type amorphous silicon (a-Si:H) layer 113 and the n-type amorphous silicon (a-Si:H) layer 115, thereby generating an electric current.

Microcrystalline silicon (µc-Si:H) is an intermediate between single crystalline silicon and amorphous silicon, and has a crystal size ranging from tens to hundreds of nanometers. In the microcrystalline silicon, an amorphous phase is frequently present at the interface between crystals and, in most cases, carrier recombination occurs due to its high defect density. Microcrystalline silicon (µc-Si:H) has an energy band gap of about 1.6eV, which is substantially the same as that of single crystalline silicon, and does not exhibit deterioration, which occurs in the amorphous silicon (a-Si:H) photovoltaic cell. The structure of the microcrystalline silicon (µc-Si:H) photovoltaic cell is very similar to that of the amorphous silicon (a-Si:H) photovoltaic cell, except for the light absorbing layer.

A single p-i-n junction thin film photovoltaic cell, which uses the amorphous silicon (a-Si:H) or the microcrystalline silicon (µc-Si:H) as the light absorbing layer, has many restrictions on its use in practice due to low light conversion efficiency. Therefore, a tandem photovoltaic cell or a triply stacked photovoltaic cell, which is fabricated by doubly or triply stacking the amorphous silicon (a-Si:H) or the microcrystalline silicon (µc-Si:H), is used, because it can raise open circuit voltage and improve light conversion efficiency by connecting the component photovoltaic cells in series.

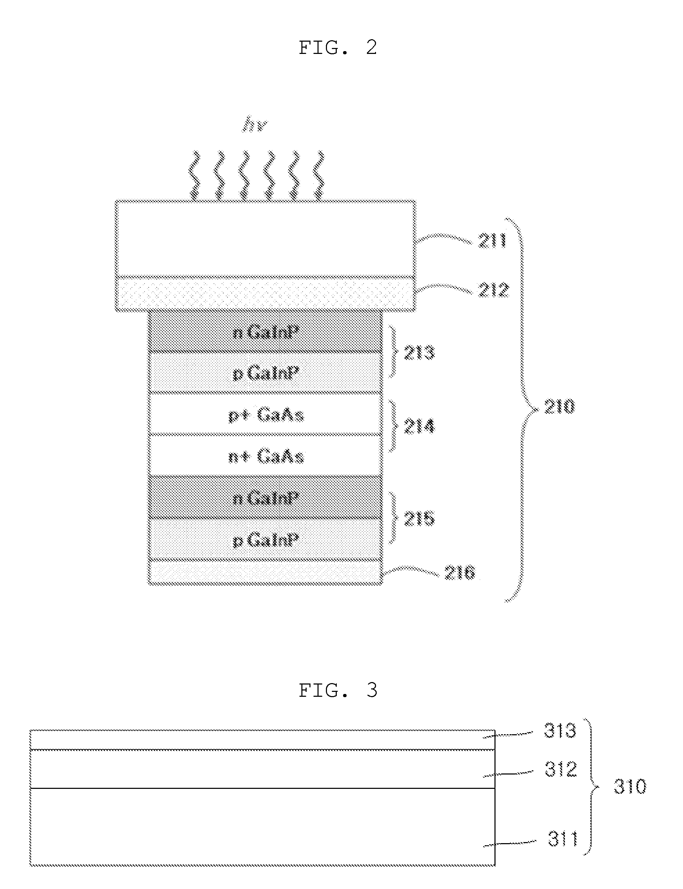

FIG. 2 is a cross-sectional view showing the structure of a tandem photovoltaic cell 210 of the related art.

As shown in FIG. 2, the tandem photovoltaic cell 210 of the related art generally includes a transparent substrate 211, a transparent conductive film 212, a first p-n junction layer 213, a tunneling p-n junction layer 214, a second p-n junction layer 215, and a back reflector film 216.

In the tandem photovoltaic cell 210 of the related art, the first p-n junction layer 213, having a predetermined band gap (e.g., E*_{g}*=1.9eV), is disposed above the second p-n junction layer 215, which has a smaller band gap (e.g., E*_{g}*=1.42eV), such that a photon having an energy of 1.42eV<*h*ν<1.9eV is allowed to pass through the first p-n junction layer 213 but is absorbed by the second p-n junction layer 215. It is possible to obtain higher light conversion efficiency by increasing the number of stacking.

The transparent conductive film used in the photovoltaic cell is required to exhibit excellent light transmittance, electrical conductivity, and light trapping efficiency. In particular, in the case of the tandem thin film photovoltaic cell, the transparent conductive film is required to show high light transmittance and a high haze value in a wide wavelength band from 350nm to 1200nm. In addition, the transparent conductive film is required to withstand hydrogen plasma.

The transparent conductive film may have tin oxide (SnO₂), as a main ingredient. However, this material has low light transmittance in a long wavelength range (of 900nm or more), thereby resulting in low light conversion efficiency, and is deteriorated by hydrogen plasma. In addition, the transparent conductive film having tin oxide (SnO₂) as its main ingredient exhibits limitations in its material properties, such as low electrical conductivity and low transmittance of about 70%.

Although Indium Tin Oxide (ITO), which is generally used as a transparent conductive film, exhibits high light transmittance of 80% or more and excellent electrical conductivity of 10⁻⁴ Ωcm, it has problems of the continuously rising of the price of the main ingredient, indium (In), which is a rare element, the high reducibility of indium in the hydrogen plasma process and resultant chemical instability, and the like.

Therefore, studies are underway for the development of a transparent conductive film that can replace the transparent film having SnO₂ or ITO as its main ingredient. Zinc oxide (ZnO) is the material that is recently gaining attention as an ideal material. Since zinc oxide can be easily doped and has a narrow conductivity band, it is easy to control the electrical-optical properties of zinc oxide depending on the type of dopant. In addition, the transparent conductive film having zinc oxide as a main ingredient is stable in the hydrogen plasma process, can be fabricated at low cost, and exhibits high light transmittance and high electrical conductivity.

However, zinc oxide loses electrical conductivity as time passes due to its poor moisture resistance. Thus, zinc oxide has a fatal defect, which can lead to deterioration in the performance and reduction of the lifetime of the photovoltaic cell. Although a method of forming a protective coating is generally performed in order to improve the moisture resistance of zinc oxide (ZnO), some problems, such as additional contact resistance and increased cost due to the additional process, are incurred. In addition, although a method of excessively doping zinc oxide (ZnO) with a dopant (e.g., gallium (Ga)) was considered, this also incurs the problem of low light transmittance even though moisture resistance is improved.

The information disclosed in this Background of the Invention section is only for the enhancement of understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a photovoltaic cell substrate and a method of manufacturing the same, in which a conductive film exhibits optical and electrical properties required in a photovoltaic cell and has excellent moisture resistance.

Also provided is a photovoltaic cell substrate and a method of manufacturing the same, in which manufacturing costs can be reduced.

In an aspect of the present invention, the photovoltaic cell substrate includes a substrate and a conductive film. The conductive film includes a zinc oxide (ZnO) which is doped with a dopant and is formed over the substrate. A surface charge activated layer is formed on the conductive film by Rapid-Thermal-Annealing.

In another aspect of the present invention, the method of manufacturing a photovoltaic cell substrate includes the following steps of: preparing a substrate; forming a conductive film over the substrate using zinc oxide (ZnO) which is doped with a dopant; and forming a charge activated layer on the surface of the conductive film by Rapid-Thermal-Annealing the conductive film, at a temperature not exceeding the softening temperature of the substrate for a time period ranging from 10 seconds to 30 minutes.

The photovoltaic cell substrate has advantageous effects in that moisture resistance is improved, since the charge activated layer formed on the surface of the conductive film prevents zinc oxide (ZnO) from reacting with external moisture. This was observed based on a variation in the sheet resistance (Ω/□) of the conductive film in a humidification test, in which the conductive film is exposed to moisture for a predetermined time period.

In addition, according to the method of manufacturing a photovoltaic cell substrate, it is possible to manufacture a zinc oxide (ZnO) conductive film having strong moisture resistance at low cost.

The methods and apparatuses of the present invention have other features and advantages which will be apparent from, or are set forth in more detail in the accompanying drawings, which are incorporated herein, and in the following Detailed Description of the Invention, which together serve to explain certain principles of the present invention.

### BRIEF DESCRIPTION OF THE DRAWINGS

FIG. 1 is a cross-sectional view showing the structure of a photovoltaic cell using amorphous silicon as a light-absorbing layer in the related art;

FIG. 2 is a cross-sectional view showing the structure of a tandem photovoltaic cell in the related art;

FIG. 3 is a cross-sectional view showing the structure of an exemplary embodiment of a photovoltaic cell substrate according to the invention;

FIG. 4 is a graph showing the light transmittance of a transparent conductive film with a charge activated layer, and that of another transparent conductive film without a charge activated layer;

FIG. 5 is a graph showing the results of a moisture resistance test performed on a transparent conductive film with a charge activated layer, and on transparent conductive films without a charge activated layer; and

FIG. 6 is a flowchart showing an exemplary embodiment of a method of manufacturing a photovoltaic cell substrate according to the invention.

### DETAILED DESCRIPTION OF THE INVENTION

Reference will now be made in detail to various embodiments of the present invention(s), examples of which are illustrated in the accompanying drawings and described below. While the invention(s) will be described in conjunction with exemplary embodiments, it will be understood that the present description is not intended to limit the invention(s) to those exemplary embodiments. On the contrary, the invention(s) is/are intended to cover not only the exemplary embodiments, but also various alternatives, modifications, equivalents and other embodiments that may be included within the spirit and scope of the invention as defined by the appended claims.

FIG. 3 is a cross-sectional view showing the structure of an exemplary embodiment of a photovoltaic cell substrate 310 according to the invention.

As shown in FIG. 3, the photovoltaic cell substrate 310 of this exemplary embodiment includes a transparent substrate 311, and a transparent conductive film 312. A charge activated layer 313 is formed on the surface of the transparent conductive film 312.

Any materials can be used for the transparent substrate 311, as long as they exhibit excellent light transmittance and mechanical properties. For example, the transparent substrate 311 can be a heat curing or Ultraviolet (UV) curing organic film, which is generally made of a polymer-based material. Examples of the polymer-based material may include Polyethylene Terephthalate (PET), acryl, Polycarbonate (PC), Urethane Acrylate (UA), polyester, Epoxy Acrylate (EA), brominate acrylate, Polyvinyl Chloride (PVC), and the like. As an alternative, the transparent substrate 311 can be a chemically tempered glass of soda-lime glass (Sio₂-CaO-Na₂O) or alumino-silicate glass (SiO₂-Al₂O-Na₂O).

The transparent conductive film 312 conducts electrical current, generated by photoelectric conversion. The transparent conductive film 312 is made of a material that has high electrical conductivity and high light transmittance. The transparent conductive film 312 is generally made of zinc oxide (ZnO). It is easy to control the electrical-optical properties of zinc oxide depending on the type of the dopant, since zinc oxide can be easily doped and has a narrow conductivity band. Since the electrical properties of zinc oxide are substantially the same as those of an insulator, zinc oxide is doped with a dopant by a plasma process to have electrical conductivity.

In an example, the dopant can be a cation dopant, such as gallium (Ga), aluminum (Al), silicon (Si), Indium (In), or carbon (C).

In another example, the dopant can be an anion dopant, such as sulfur (S) or nitrogen (N). In a further example, Zinc Oxide may be co-doped with two or more of the cation and anion dopants.

The transparent conductive film 312 can be formed through Plasma Enhanced Chemical Vapor Deposition (PECVD), Chemical Vapor Deposition (CVD), Low Pressure CVD (LPCVD), Atmospheric Pressure CVD (APCVD), sputtering, or the like.

The charge activated layer 313 is formed on the surface of the transparent conductive film 312 in order to improve the moisture resistance of the transparent conductive film 312. Zinc oxide which is used as the main ingredient of the transparent conductive film 312 easily bonds with moisture in the air (e.g., H₂O, OH, and H), which causes the characteristics of zinc oxide to deteriorate, for example, causes the resistivity of zinc oxide to increase. The charge activated layer 313 can be formed by Rapid-Thermal-Annealing the transparent conductive film 312, which is formed over the transparent substrate 311. For example, the Rapid-Thermal-Annealing may be carried out by using a lamp or irradiating with laser.

Conventionally, heat treatment is reportedly applied to the transparent conductive film 312 in order to improve the crystallinity or electrical conductivity of the transparent conductive film 312. In general, when the electrical conductivity of the transparent conductive film 312 increases, the optical band gap also increases due to the Burnstein-Moss effect. Generally, the optical band gap indicates an average optical band gap all over the transparent conductive film 312. However, this exemplary embodiment of the invention aims to apply the heat treatment on the transparent conductive film 312 in such a manner that the charge activated layer 313, which has high charge density, can be formed only on the surface of the transparent conductive film 312 without varying the microscopic structure of the inner part of the transparent conductive film 312. For example, the charge activated layer 313 can be formed by a method of leaving the transparent conductive film 311, inside a heat treatment reactor, at a temperature not exceeding the softening point of the transparent substrate for a time period ranging from 10 seconds to 30 minutes.

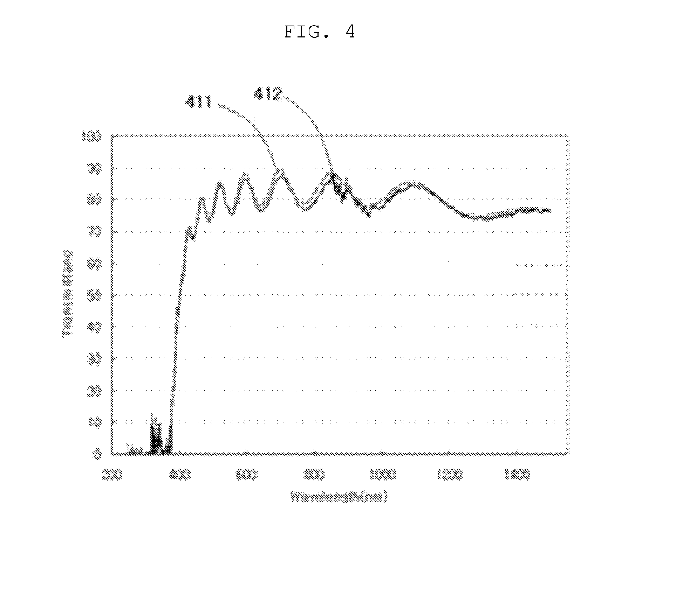

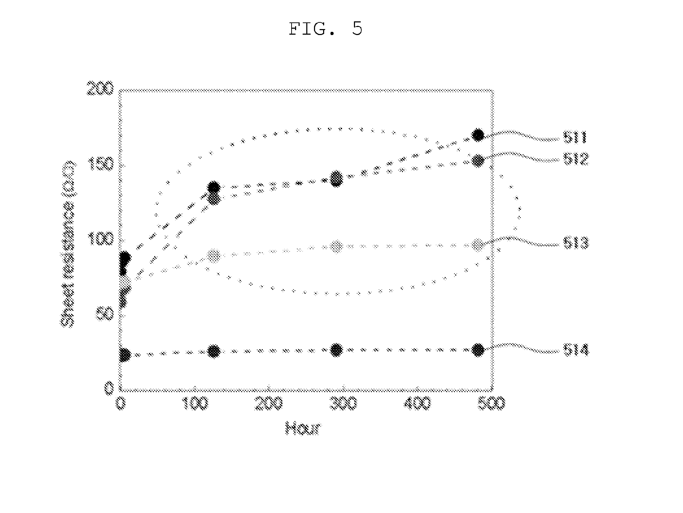

FIG. 4 is a graph showing the light transmittance of a transparent conductive film with a charge activated layer, and that of another transparent conductive film without a charge activated layer. FIG. 5 is a graph showing the results of a moisture resistance test performed on a transparent conductive film with a charge activated layer, and on transparent conductive films without a charge activated layer.

First, referring to FIG. 4, reference numeral 411 indicates a light transmittance curve of the transparent conductive film which has a charge activated layer on the surface thereof, and reference numeral 412 indicates a light transmittance curve of the transparent conductive film which does not have a charge activated layer on a surface thereof. As shown in FIG. 4, it can be appreciated that there is substantially no differences when comparing the light transmittance curve of the transparent conductive film with the charge activated layer, with the light transmittance curve of the transparent conductive film without a charge activated layer.

Next, referring to FIG. 5, reference numerals 511 to 513 indicate the results of the moisture resistance test performed on the transparent conductive films which has a charge activated layer on the surface thereof, and reference numeral 514 indicates the result of the moisture resistance test performed on a transparent conductive film without a charge activated layer. The moisture resistance test was performed by measuring sheet resistance (Ω/□) while exposing the transparent conductive films for 500 hours to the condition of 90% moisture and a temperature of 85°C (see 511 to 514). Here, the transparent conductive film is a transparent film of zinc oxide (ZnO) which is doped with gallium (Ga). The charge activated layer was formed on a surface of the transparent substrate by a method of leaving the transparent substrate over which the transparent conductive film is formed, at a temperature below the softening temperature thereof for a time period ranging from 10 seconds to 30 minutes.

As shown in FIG. 5, the transparent conductive films which do not have a charge activated film, exhibit an increase in sheet resistance (Ω/□) ranging from 30% to 300% as time passes (see 511 to 513), whereas the transparent conductive film which have the charge activated film on the surface thereover, exhibits substantially no variation in sheet resistance (Ω/□) as time passes (see 514).

When taking the results of FIGS. 4 and 5 into consideration, it can be understood that the heat treatment increased only the charge density in the surface of the transparent conductive film. It can also be understood that the moisture resistance of the transparent conductive film was improved, since the charge activated layer formed on the surface of the transparent conductive film prevented zinc oxide, i.e., the main ingredient of the transparent conductive film, from reacting with external moisture.

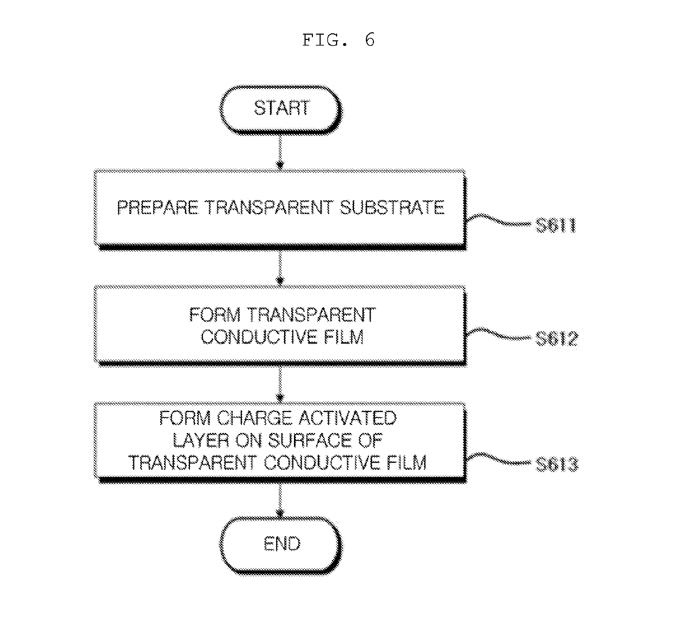

FIG. 6 is a flowchart showing an exemplary embodiment of a method of manufacturing a photovoltaic cell substrate according to the invention.

As shown in FIG. 6, the method of manufacturing a photovoltaic cell substrate of this exemplary embodiment includes the step S611 of preparing a transparent substrate. Any transparent substrates can be used as long as they exhibit excellent light transmittance, low haze, and good mechanical properties. For example, the transparent substrate can be a heat curing or Ultraviolet (UV) curing organic film, which is generally made of a polymer-based material. Examples of the polymer-based material may include Polyethylene Terephthalate (PET), acryl, Polycarbonate (PC), Urethane Acrylate (UA), polyester, Epoxy Acrylate (EA), brominate acrylate, Polyvinyl Chloride (PVC), and the like. As an alternative, the transparent substrate 311 can be a chemically tempered glass of soda-lime glass (Sio₂-CaO-Na₂O) or alumino-silicate glass (SiO₂-Al₂O-Na₂O).

Afterwards, in S612, a transparent conductive film, which has ZnO doped with a dopant, is formed over the transparent substrate. The step S612 of forming the transparent conductive film can form the transparent conductive film by, for example, Plasma Enhanced Chemical Vapor Deposition (PECVD), Chemical Vapor Deposition (CVD), Low Pressure CVD (LPCVD), Atmospheric Pressure CVD (APCVD), sputtering, or the like.

In an example, the dopant can be a cation dopant, such as gallium (Ga), aluminum (Al), silicon (Si), Indium (In), or carbon (C). In another example, the dopant can be an anion dopant, such as sulfur (S) or nitrogen (N). In a further example, Zinc Oxide may be co-doped with two or more of the cation and anion dopants.

Afterwards, in S613, a charge activated layer is formed on a surface of the transparent substrate by leaving the transparent substrate, inside a heat treatment reactor, at a temperature not exceeding the softening temperature of the transparent substrate for a time period ranging from 10 seconds to 30 minutes. The charge activated layer in which the dopant is activated, is formed on the surface of the transparent conductive layer to raise the moisture resistance of the transparent conductive film. Zinc oxide which is used as the main ingredient of the transparent conductive film 312 easily bonds with moisture in the air (e.g., H₂O, OH, and H), which causes the characteristics of zinc oxide to deteriorate, for example, causes the resistivity of zinc oxide to increase. The charge activated layer can be formed by Rapid-Thermal-Annealing the transparent conductive film, which is formed over the transparent substrate. For example, the Rapid-Thermal-Annealing may be carried out by using a lamp or irradiating with laser. The heat treatment reactor carries out a heat treatment process in a nitrogen atmosphere or an argon atmosphere.

In the step of forming the charge activated layer on the surface of the transparent conductive film, if the transparent substrate over which the transparent conductive film is formed is a glass substrate, the charge activated layer can be formed on the surface of the transparent conductive film by leaving the transparent substrate at a temperature ranging from 200°C to 650°C for a time period ranging from 10 seconds to 30 minutes.

The foregoing descriptions of specific exemplary embodiments of the present invention have been presented for the purposes of illustration and description. They are not intended to be exhaustive or to limit the invention to the precise forms disclosed, and obviously many modifications and variations are possible in light of the above teachings. The exemplary embodiments were chosen and described in order to explain certain principles of the invention and their practical application, to thereby enable others skilled in the art to make and utilize various exemplary embodiments of the present invention, as well as various alternatives and modifications thereof. It is intended that the scope of the invention be defined by the Claims appended hereto and their equivalents.

## Claims

1. A photovoltaic cell substrate comprising:
a transparent substrate; and
a transparent conductive film, wherein the transparent conductive film comprises zinc oxide which is doped with a dopant and is formed over the transparent substrate, and a surface charge activated layer is formed on a surface of the transparent conductive film by Rapid-Thermal-Annealing.

2. The photovoltaic cell substrate according to claim 1, wherein the dopant comprises one or more selected from the group consisting of gallium, aluminum, silicon, Indium, carbon, sulfur, and nitrogen.

3. A method of manufacturing a photovoltaic cell substrate, comprising:
preparing a transparent substrate;
forming a transparent conductive film over the transparent substrate using zinc oxide, which is doped with a dopant; and
forming a charge activated layer on a surface of the transparent conductive film by Rapid-Thermal-Annealing the transparent conductive film, at a temperature not exceeding a softening temperature of the transparent substrate for a time period ranging from 10 seconds to 30 minutes.

4. The method according to claim 3, wherein the transparent substrate is a glass, and wherein the charge activated layer is
formed on the surface of the transparent conductive film by Rapid-Thermal-Annealing the transparent conductive film at a temperature ranging from 200°C to 650°C.

5. The method according to claim 3, wherein the transparent conductive film is Rapid-Thermal-Annealed in a nitrogen atmosphere or an argon atmosphere.

6. The method of manufacturing a photovoltaic cell substrate according to claim 3, wherein the dopant comprises one or more selected from the group consisting of gallium, aluminum, silicon, Indium, carbon, sulfur, and nitrogen.
